# EUROPÄISCHE PATENTSCHRIFT

(11) **EP 0 341 471 B1**
(45) Veröffentlichungstag und Bekanntmachung des Hinweises auf die Patenterteilung: **13.07.1994**
(21) Anmeldenummer: 89107308.2
(22) Anmeldetag: 25.04.1989
(51) Int. Cl.: H01L 21/56, H01L 21/312

(54) **Verfahren zur Verkapselung von elektronischen Bauelementen**
Method for encapsulating electronic components
Procédé pour l'encapsulation des composants électroniques

(30) Priorität: 13.05.1988 DE 3816457
(43) Veröffentlichungstag der Anmeldung: 15.11.1989
(73) Patentinhaber: Potje-Kamloth, Karin, D-85521 Ottobrunn (DE); Josowicz, Mira, Dr., D-85521 Ottobrunn (DE)
(72) Erfinder: Potje-Kamloth, Karin, D-85521 Ottobrunn (DE); Josowicz, Mira, Dr., D-85521 Ottobrunn (DE)
(74) Vertreter: Baumann, Eduard, Dipl.-Phys.

(56) Entgegenhaltungen:
- JOURNAL OF THE ELECTROCHEMICAL SOCIETY, vol. 128, no. 11, November 1981, MANCHESTER, NEW HAMP Seiten 2276 - 2281; G. MENGOLI et al: "Protective coatings by anodic coupling polymerization of o-allylphenol"
- JOURNAL OF THE ELECTROCHEMICAL SOCIETY, vol. 119, no. 12, Dezember 1981, MANCHESTER, NEW HAMP Seiten 1645 - 1649; D.C. PHILLIPS: "Electrolytically formed polyimide films and coatings"

## Beschreibung

Die Erfindung betrifft ein Verfahren zur Verkapselung bzw. Isolierung von elektrisch leitenden Bereichen in einem elektronischen Bauelement, wie z.B. Feldeffekt-Transistoren oder Dioden.

Die Verkapselung von elektrisch leitenden Bereichen in elektronischen Bauelement ist notwendig, damit die Bauelemente im Betrieb vor Korrosion geschützt sind. So ist es beispielsweise bei chemisch sensitiven Feldeffekt-Transistoren wichtig, daß sie in Elektrolytlösungen funktionsfähig bleiben. Von Verkapselungsmaterialien wird gefordert, daß sie keine Durchlässigkeit für Wasser oder den Elektrolyten haben, eine gute Haftung gewährleisten und gute mechanische Eigenschaften haben.

Aus der Literaturstelle Solid State Chemical Sensors, herausgegeben von Jiri Janata und Robert J. Huber, Seiten 153-157, Academic Press, Inc., New York, (1985) ist die Verkapselung von chemisch sensitiven Feldeffekt-Transistoren beschrieben. Als Verkapselungsmaterial werden Siliconkautschuke und Epoxyharze verwendet. Diese Verkapselung erfolgt per Hand, was insbesondere im Gatebereich schwierig ist, der von Isolierschicht freibleiben muß. Um diese Schwierigkeiten zu beheben, hat man insbesondere die rheologischen Eigenschaften der noch nicht gehärteten Verkapselungsmaterialien modifiziert.

Aufgabe der Erfindung besteht in einem Verfahren zur Verkapselung von elektrisch leitenden Bereichen in einem elektronischen Bauelement, das mit höherer Genauigkeit und Produktivität durchgeführt werden kann und zu fest haftenden gleichmäßig ausgebildeten Isolierschichten mit hoher chemischer Resistenz und Durchbruchsspannung führt.

Diese Aufgabe wird mit den Merkmalen des Patentanspruchs 1 gelöst. Vorteilhafte Ausgestaltungen sind in den Unteransprüchen erwähnt.

Durch die elektrochemische Ausbildung der Isolierschichten kann eine sehr dünne und gleichmäßige Schicht auf elektrische leitende Bereiche aufgebracht werden. Hierbei können durch einfache elektrische Kontaktierung nur diejenigen elektrisch leitenden Bereiche, die verkapselt bzw. isoliert werden sollen, geschützt werden. Das Verfahren erlaubt eine automatische Herstellung mit hoher Produktivität und guter Reproduzierbarkeit. Die gebildeten Isolierschichten sind sehr fest haftend und chemisch resistent.

Die Verwendung von Poly-4-oxyphenylen als Korrosionsschutzschichten ist in der Literaturstelle J. Electochem. Soc. Electrochemical Science and Technology, Seite 2276-2281 (1981) beschrieben. Solche Korrosionsschutzschichten zeigten bei einer Dicke von wenigstens 10 »m gute physikalische Eigenschaften, insbesondere Korrosionsfestigkeit. Es wird berichtet, daß die Schichten mit einer Dicke von lediglich 1 bis 2 »m weder einen verbesserten Metallschutz noch Vorteile bei der Härtung bzw. beim Vernetzen zeigten. Die Verwendung von Poly-4-oxyphenylen-Schichten als Isoliermaterial für die Verkapselung von elektrisch leitenden Bereichen in einem elektronischen Bauelement ist nicht angesprochen.

Die Erfindung wird unter Bezugnahme auf die nachfolgenden Zeichnungen näher erläutert.
- Fig. 1: zeigt ein unverkapseltes elektronisches Bauelement in Form eines Feldeffekt-Transistors.
- Fig. 2: zeigt ein verkapseltes elektronisches Bauelement gemäß Fig. 1.
- Fig. 3: ist eine schematische Darstellung des Aufbaues zum Aufbringen der Verkapselung durch elektrochemische Abscheidung.

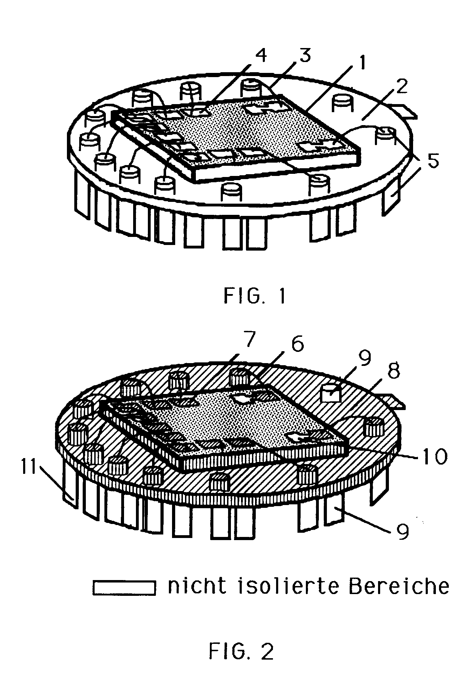

Fig. 1 zeigt einen Transistorchip (1), der von der Rückseite mit einem Transistorgehäuse (2) kontaktiert ist. Die Pins (5) sind mit den Bondkontakten des Transistors (4) über einen Bonddraht (3) elektrisch verbunden.

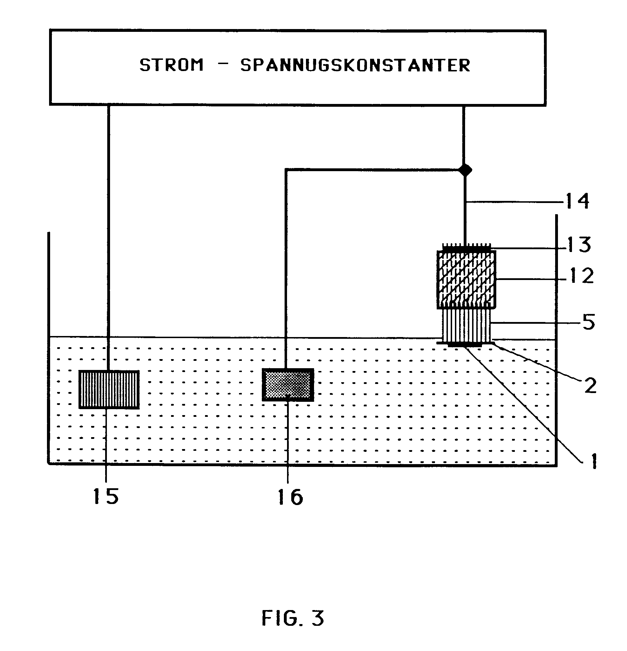

Zur Abscheidung wird das in Fig. 1 schematisch dargestellte elektrische Bauteil auf einen Transistorsocket (12) aufgesteckt, entsprechend dem Aufbau zum Aufbringen der Verkapselung in Fig. 3. Die Zuleitungen (13) des Transistorsocket (12) werden miteinander so verlötet, daß zu allen Bereichen des Bauelementes, die isoliert werden sollen, ein elektrischer Kontakt hergestellt ist. Die miteinander elektrisch verbundenen Zuleitungen (13) des Transistorsocket (12) werden mit einem stromzuführenden Draht (14) elektrisch verbunden.

Die gesamte Einheit wird als Arbeitselektrode verwendet und über einen Strom/Spannungskonstanter mit zwei Metallelektroden (15) und (16) kontaktiert. Die Elektrode (15) besteht aus Edelmetall, etwa Platin. Die Metallelektrode (16) ist parallel mit der Arbeitselektrode kontaktiert. Die Metallelektrode (16) hat die Funktion einer Ballastelektrode und wird für die Bestimmung der Dicke der Isolierschicht verwendet, was durch Überprüfung der Abscheidungsrate erfolgt. (Messung mit einem Profilometer). Als Metalle der Ballastelektrode werden solche Materialien bevorzugt, die bei der Herstellung der Bondkontakte (4) am Transistorchip (1) verwendet werden.

Damit eine gute Haftung zwischen der Isolierschicht und den elektrisch leitenden Bereichen gewährleistet wird, werden vor der Abscheidung der Polymerschicht die elektrisch leitenden Bereiche chemisch und/oder elektrochemisch geätzt, um eventuell vorhandene Passivierungsschichten zu entfernen. Ein geeignetes Verfahren besteht in einem elektrochemischen Ätzen mit einer Lösung von Ethylendiamintetraacetat, Ammoniak und Wasserstoffperoxid bei pulsierender Spannung von 0 bis + 2 V für eine Zeitspanne von 5 bis 10 Minuten. Anschließend wird an die Elektrode eine Spannung von + 0,4 bis - 0,4 V in einer 1 M KNO₃-Lösung 10 Minuten lang angelegt.

Die elektrisch leitenden Bereiche, die elektrisch nicht isoliert werden sollen, werden durch Metalle gebildet, die leicht passivierende Oxidschichten bilden. Als Metalle, die nicht elektrisch isoliert werden sollen, können Titan, Wolfram, Tantal, Aluminium, Molybdän oder eine Legierung davon verwendet werden.
Es ist auch möglich, elektrisch leitende Bereiche, die nicht isoliert werden sollen, vor der elektrochemischen Abscheidung durch einen Galvanoresist zu schützen. Geeignete Galvanoresiste sind im Handel erhältlich.

Zum Aufbringen der Isolierschicht wird die Arbeitselektrode in ein Elektrolytbad eingetaucht, in der eine Polymerschicht durch elektrochemische Polymerisation von Phenol, Thiophenol- und/oder Anilinhaltigen Monomeren gebildet wird. Die elektrochemisch gebildete Polymerschicht ist aus linearen Polymerketten aufgebaut. Damit lineare Polymerketten gebildet werden können, weist der Phenylrest des Monomeren in ortho-Stellung einen aliphatischen Rest auf, der bis zu 10 Kohlenstoffatomen, vorzugsweise bis zu 5 Kohlenstoffatomen enthält. Der Phenylrest des Monomeren weist hierbei wenigstens einen ungesättigten aliphatischen Rest mit 2 bis 10 Kohlenstoffatomen, vorzeugsweise 2 bis 5 Kohlenstoffatomen auf, der insbesondere in ortho-Stellung vorhanden ist. Geeignete Monomere sind 2-Allylphenol, 2-Allylthiophenol und 2-Allylanilin bzw. entsprechende Vinylverbindungen. Bis zu einem Anteil von 20 Mol% können Monomere mit einer gesättigten aliphatischen Gruppe, wie Kresol neben den ungesättigten Monomeren als Comonomere verwendet werden.

Ein bei der elektrochemischen Abscheidung bevorzugt gebildetes lineares Polymer hat folgende wiederholende Einheit: 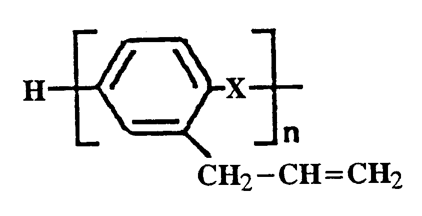
X=0, S, NH.

Die elektrochemische Abscheidung erfolgt vorzugsweise in einem wäßrigen, alkalischen Milieu an der Anode. Vorzugsweise wird eine Wasser-Alkohol-Mischung verwendet, wobei das Mischungsverhältnis (Volumen) bei 1:10 bis 10:1, vorzugsweise 1:5 bis 5:1 liegt. Ein niederer aliphatischer Alkohol ist bevorzugt. Die Elektrolytlösung enthält neben den Monomeren ein Amin oder eine wässrige Ammoniklösung, um die Passivierung der Elektrodenoberfläche zu unterdrücken. Vorzugsweise ist das Amin ein primäres Amin mit einer ungesättigten aliphatischen Gruppe. Beispielhafte Amine sind Allylamin und Propylamin.

Vorzugsweise enthält die Elektrolytlösung einen Adhäsionsverbesserer, um die Haftung der Isolierschicht an den zu isolierenden elektrischen Bereichen zu fördern. Geeignete Adhäsionsverbesserer sind Ethylenglykolmonobutyläther und Butoxymethanol. Der Adhäsionsverbesserer wird ein einem Anteil von 1 bis 10 Volumen% der Elektrolytlösung verwendet.

Die auf den elektrisch leitenden Bereichen abgeschiedene Polymerschicht ist zwar in wäßrigen System unlöslich, kann jedoch in verschiedenen organischen Lösungsmitteln wieder aufgelöst werden. Damit eine festhaftende Isolierschicht gebildet wird, muß daher die Polymerschicht über die ungesättigten Gruppen vernetzt werden. Die Vernetzung der ungesättigten Gruppen erfolgt durch Erhitzen oder Bestrahlung (z.B. UV-Strahlung). Zweckmäßigerweise wird nach der Abscheidung des Polymers eine Temperaturbehandlung, vorzugsweise bei 120 bis 200°C, insbesondere bei 150°C durchgeführt. Hierzu wird das Gehäuse mit dem Bauelement ohne den Transistorsocket (12), wie in Fig. 3 dargestellt ist, in einem Ofen bei 150°C 30 Minuten lang erhitzt. Durch die Vernetzung wird die abgeschiedene Polymerschicht in einen Isolator umgewandelt.

Die elektrochemische Polymerisation erfolgt zweckmäßigerweise in einem bewegten Elektrolyten, beispielsweise in einer Durchflußzelle, da diese die Abscheidung aufgrund der Diffusion der Monomeren zur Elektrode begünstigt. Alternativ oder zusätzlich kann die Abscheidung auch unter einem geringen Vakuum vorteilhaft durchgeführt werden. Die elektrochemische Polymerisation erfolgt bei 20°C bis 50°C, wobei Raumtemperatur bevorzugt ist. Es wird bei konstantem Potential vorzugsweise bei 2 bis 8 V, insbesondere 4 bis 6 V gearbeitet.

Die auf den elektrisch leitenden Bereichen aufgebrachte Isolierschicht hat eine Dicke von 1,0 bis 20 »m, vorzugsweise 1 bis 8 »m. Es wurde gefunden, daß eine Isolierschicht mit einer derartigen Schichtdicke gut haftet und den gewünschten Isoliereffekt liefert.

In Fig. 2 ist ein bevorzugtes verkapseltes Bauelement schematisch dargestellt. Wie in der Fig. 2 ersichtlich ist, stellen die schraffierten Bereiche isolierte Bereiche dar, wie die Kontaktierungsdrähte (6), die Bondkontakte des Transistors (7), und das Gehäuse (8), auf welches das Bauelement montiert ist. Der nicht kontaktierte Pin des Gehäuses (9), welches im Elektrolyt eingetaucht war und die anderen Pins (11), welche in den Elektrolyten nicht eingetaucht waren sowie auch teilweise abgedeckte Bereiche der Bondkontakte (10) (z.B. mit einem Galvanoresist) werden nicht beschichtet und folglich nicht isoliert.

Die so hergestellten verkapselten elektronischen Bauelemente etwa in Form des in Fig. 1 gezeigten Feldeffekt-Transistorchip können als chemische bzw. als physikalische Sensoren verwendet werden. Hierzu werden in den Gate-Bereichen des Transistors physikalisch oder chemisch sensitive Schichten, beispielsweise wasserstoffsensitive Palladiumschichten aufgebracht.
Die Erfindung wird unter Bezugnahme auf ein Beispiel näher erläutert.

### Beispiel

Es wurde ein Feldeffekt-Transistor der in Fig. 1 gezeigten Bauart verkapselt, wobei das in Fig. 3 gezeigte Verkapselungsschema verwendet wurde. Die gemäß Fig. 3 zusammengestellte Arbeitselektrode wurde in einer Elektrolytlösung anodisch beschichtet, die folgende Bestandteile enthielt:
0,23 Mol/l 2-Allylphenol
0,40 Mol/l Allylamin
0,20 Mol/l Cellosolve (Ethylenglykolmonobutyläther)
Diese Bestandteile waren in einer Mischung von Methanol und Wasser (Volumenteile 1:1) gelöst.

Die elektrochemische Polymerisation wurde bei einem konstanten Potential von 4 V bei Zimmertemperatur 30 Minuten lang durchgeführt. Nach der Abscheidung des Polymers wird nur das Gehäuse mit dem Bauelement ohne den Transistorsocket (12), wie in Fig. 3 dargestellt, in einem Ofen bei 150°C 30 Minuten lang erhitzt, wodurch eine Vernetzung der abgeschiedenen Polymerschicht zu einer Isolierschicht erfolgt. Die verkapselten Bereiche des Feldeffekt-Transistors sind in Fig. 2 gezeigt. Die auf den elektrisch leitenden Bereichen gebildete Isolierschicht wies eine gleichmäßige Schichtdicke von 1,5 »m auf. Die Schichtdicke war sehr festhaftend und in üblichen Elektrolytlösungen chemisch resistent. Der verkapselte Feldeffekt-Transistor konnte wiederholt für einen chemischen oder physikalischen Sensor verwendet werden.

## Patentansprüche

1. Verfahren zur Verkapselung von elektrisch leitenden Bereichen in einem elektronischen Bauelement durch Aufbringen einer Isolierschicht, wobei
- die elektrisch leitenden Bereiche, die isoliert werden sollen, vor der Verkapselung chemisch und/oder elektrochemisch zur Entfernung der auf den electrisch leitenden Bereichen vorhandenen Passivierungsschicht gereinigt werden,
- die elektrisch leitenden Bereiche, die elektrisch nicht isoliert werden sollen, vor der Verkapselung durch Metalle abgedeckt werden, die leicht passivierende Oxidschichten bilden, insbesondere Titan, Wolfram, Tantal, Aluminium, Molybdän oder eine Legierung davon oder durch einen Galvonoresist auf organischer Basis geschützt werden und
- daß auf denjenigen elektrisch leitenden Bereichen, die verkapselt bzw. isoliert werden sollen, eine Polymerschicht durch elektrochemische Polymerisation von Phenol-, Thiophenol- und/ oder Anilinhaltigen Monomeren in einer Elektrolytlösung abgeschieden wird, welche anschließend zu einer chemisch resistenten Isolierschicht vernetzt wird.

2. Verfahren nach Anspruch 1, dadurch gekennzeichnet, daß die Polymerschicht aus linearen Polymerketten aufgebaut ist.

3. Verfahren nach Anspruch 1 oder 2, dadurch gekennzeichnet, daß der Phenylrest des Monomeren in ortho-Stellung einen aliphatischen Rest enthält.

4. Verfahren nach einem der vorhergehenden Ansprüche, dadurch gekennzeichnet, daß der Phenylrest des Monomeren wenigstens einen ungesättigten aliphatischen Rest mit 2 bis 10 Kohlenstoffatomen enthält, der in ortho-Stellung vorhanden ist.

5. Verfahren nach einem der vorhergehenden Ansprüche, dadurch gekennzeichnet, diejenigen elektrisch leitenden Bereiche des Bauelementes, die isoliert werden sollen, über Bonddrähte verbunden und über einen stromzuführenden Draht als Anode geschaltet werden.

6. Verfahren nach einem der vorhergehenden Ansprüche, dadurch gekennzeichnet, daß die elektrochemische Abscheidung der Polymerschicht im wäßrigen alkalischen Milieu bei 20°C bis 50°C erfolgt.

7. Verfahren nach einem der vorhergehenden Ansprüche, dadurch gekennzeichnet, daß die Elektrolytlösung ein Amin, insbesondere ein primäres Amin mit einer aliphatischen Gruppe oder eine wässrige Ammoniaklösung enthält.

8. Verfahren nach einem der vorhergehenden Ansprüche, dadurch gekennzeichnet, daS die Elektrolytlösung einen Adhäsionsverbesserer enthält.

9. Verfahren nach einem der vorhergehenden Ansprüche, dadurch gekennzeichnet, daß die Vernetzung der Polymerschicht durch Erhitzen oder durch Bestrahlung erfolgt.

10. Verfahren nach Anspruch 9, dadurch gekennzeichnet, daß die Vernetzung bei einer Temperatur von 120 bis 200°C durchgeführt wird.

11. Verfahren nach einem der vorhergehenden Ansprüche, dadurch gekennzeichnet, daß die Isolierschicht mit einer Dicke von 1,0 - 20 »m aufgebracht wird.

## Claims

1. Process for incapsulating electrically conductive zones in an electronic component by depositing a insulating layer, whereby
- the electrically conductive zones, which are to be insulated, are cleaned chemically and/or electrochemically to remove the passivation layer present on the electrically conductive zones prior incapsulation,
- the electrically conductive zones which are not to be insulated electrically prior incapsulation are covered by metals which form easily passivating oxide layers, especially titanium, wolfram, tantalum, aluminum, molybdenum or a alloy thereof or are protected by a galvanoresist on a organic basis and
- a polymer layer is deposited on these electrically conductive zones which are to be incapsulated or insulated respectively by electrochemical polymerisation of phenol, thiophenol and/or aniline containing monomers in a electrolyte solution which is subsequently crosslinked to a chemically resistant insulation layer.

2. Process according to claim 1,
**characterized in that**
the polymer layer consists of linear polymer chains.

3. Process according to claim 1 or 2,
**characterized in that**
the phenyl remainder of the monomer in ortho position contains an aliphatic remainder.

4. Process according to one of the foregoing claims,
**characterized in that**
the phenyl remainder of the monomer at least contains an unsaturated aliphatic remainder of 2 to 10 carbon atoms which is present in ortho position.

5. Process according to one of the foregoing claims,
**characterized in that**
those electrically conductive zones of the component which are to be insulated are connected by bond wires and are connected by a lead-in wire as an anode.

6. Process according to one of the foregoing claims,
**characterized in that**
the electrochemical deposition of the polymer layer in the aqueous, alkaline medium takes place at 20°C to 50°C.

7. Process according to one of the foregoing claims,
**characterized in that**
the electrolyte solution contains an amine, especially a primary amine with an aliphatic group or an aqueous ammonia solution.

8. Process according to one of the foregoing claims,
**characterized in that**
the electrolyte solution contains an adhesion improver.

9. Process according to one of the foregoing claims,
**characterized in that**
the polymer layer is cross-linked by heating or radiation.

10. Process according to claim 9,
**characterized in that**
the cross-linking is carried out at a temperature of 120°C to 200°.

11. Process according to one of the foregoing claims,
**characterized in that**
the insulation layer is deposited with a thickness of 1.0 to 20 »m.

## Revendications

1. Procédé pour l'encapsulation des zones conductrices d'électricité d'un composant électronique par application d'une couche isolante,
- les zones conductrices destinées à être isolées étant nettoyées chimiquement et/ou électroniquement avant l'encapsulation afin d'en ôter la couche passivante existant sur les zones conductrices,
- les zones conductrices ne devant pas être isolées étant recouvertes avant l'encapsulation de métaux formant facilement des couches oxydiques passivantes, en particulier le titan, le tungstène₁ le tantale, l'aluminium, le molybdène, ou un alliage de ces métaux, ou bien étant protégées par une matière à base organique résistante à la galvanisation,
- une couche polymère étant déposée par voie de polymérisation électrochimique de phénole, tiophénole et/ou monomères à teneur d'aniline dans une solution électrolyte sur les zones conductrices destinées à être encapsulées ou isolées, cette couche polymère étant ensuite réticulée en vue de former une couche isolante chimiquement résistante.

2. Procédé selon la revendication 1, caractérisé en ce que la couche de polymère est constituée de chaînes polymères linéaires.

3. Procédé selon la revendication 1 ou 2, caractérisé en ce que le reste de phényle du monomère en position ortho contient un reste aliphatique.

4. Procédé selon l'une des revendications précédentes, caractérisé en ce que le reste de phényle du monomère contient au moins un reste aliphatique non saturé avec 2 à 10 atomes de carbone en position ortho.

5. Procédé selon l'une des revendications précédentes, caractérisé en ce que les zones conductrices du composant destinées à être isolées sont reliées à l'aide de fils de Bond et mises en circuit par l'intermédiaire d'un fil d'alimentation en courant pour faire fonction d'anode.

6. Procédé selon l'une des revendications précédentes, caractérisé en ce que la séparation électrochimique de la couche polymère est effectuée en milieu aqueux alcalique à une température de 20°C à 50°C.

7. Procédé selon l'une des revendications précédentes, caractérisé en ce que la solution électrolyte est une amine, en particulier une amine primaire contenant un groupe aliphatique ou une solution amoniaque aqueuse.

8. Procédé selon l'une des revendications précédentes, caractérisé en ce que la solution électrolyte contient un améliorateur d'adhérence.

9. Procédé selon l'une des revendications précédentes, caractérisé en ce que la réticulation de la couche polymère est effectuée par chauffage ou irradiation.

10. Procédé selon la revendication 9, caractérisé en ce que la réticulation est effectuée à une température de 120 à 200°C.

11. Procédé selon l'une des revendications précédentes, caractérisé en ce que la couche isolante est appliquée sur une épaisseur de 1,0 à 20 »m.
